# EUROPÄISCHE PATENTSCHRIFT

(11) **EP 1 390 978 B1**
(45) Veröffentlichungstag und Bekanntmachung des Hinweises auf die Patenterteilung: **18.04.2007**
(21) Anmeldenummer: 02726094.2
(22) Anmeldetag: 21.05.2002
(51) Int. Cl.: H01L 21/8246, H01L 27/22

(54) **HALBLEITERSPEICHEREINRICHTUNG SOWIE VERFAHREN ZU DEREN HERSTELLUNG**
SEMICONDUCTOR MEMORY DEVICE AND METHOD FOR THE PRODUCTION THEREOF
SYSTEME DE MEMOIRE A SEMI-CONDUCTEURS ET PROCEDE PERMETTANT DE LE PRODUIRE

(30) Priorität: 25.05.2001 DE 10125594
(43) Veröffentlichungstag der Anmeldung: 25.02.2004
(73) Patentinhaber: Qimonda AG, 81739 München (DE)
(72) Erfinder: NUETZEL, Joachim, East Fishkill, NY 12533 (US); SCHLOESSER, Till, 01109 Dresden (DE); SCHWARZL, Siegfried, 85579 Neubiberg (DE); WURM, Stefan, Dublin, CA 94568 (US)
(74) Vertreter: Kottmann, Heinz Dieter
(86) Internationale Anmeldenummer: PCT/DE2002/001818
(87) Internationale Veröffentlichungsnummer: WO 2002/095794

(56) Entgegenhaltungen:
- US-A1- 2002 140 060
- PATENT ABSTRACTS OF JAPAN vol. 2000, no. 21, 3. August 2001 (2001-08-03) -& JP 2001 101859 A (TOSHIBA CORP), 13. April 2001 (2001-04-13)

## Beschreibung

Die Erfindung betrifft ein Verfahren zur Herstellung einer Halbleiterspeichereinrichtung gemäß dem Oberbegriff des Anspruchs 1 sowie eine entsprechende Halbleiterspeichereinrichtung gemäß dem Oberbegriff des Anspruchs 13.

Ziel der Weiterentwicklung moderner Halbleiterspeichertechnologien sind z. B. die Steigerung der Integrationsdichte, der Ausbau der Funktionszuverlässigkeit sowie die Vereinfachung entsprechender Herstellungsverfahren.

Bei vielen Halbleiterspeichereinrichtungen sind neben den eigentlichen Speicherzellen oder Speicherelementen auch weitere Bauelemente, passiver oder aktiver Natur, on-chip zu realisieren. Insbesondere besteht bei dem Aufbau sogenannter kapazitiver Elemente oder integrierter Kondensatoren die Schwierigkeit, dass diese bei bekannten Herstellungsverfahren und/oder bei bekannten Speichergeometrien nicht ohne zusätzliche Prozessschritte und/oder nicht ohne ein Aufweichen der Geometrien realisierbar sind.

Dokument EP-A-1253651 beschreibt eine Halbleiterspeichereinrichtung mit einem magnetoresistiven Element.

Der Erfindung liegt die Aufgabe zugrunde, eine Halbleiterspeichereinrichtung sowie ein Verfahren zu deren Herstellung anzugeben, bei welchen vorzusehende Kondensatoreinrichtungen auf besonders einfache und zuverlässige Art und Weise in den bestehenden Prozessablauf bzw. in die bestehende Speichergeometrie integriert ausgebildet werden können.

Gelöst wird die Aufgabe verfahrensmäßig durch ein gattungsgemäßes Verfahren erfindungsgemäß mit den kennzeichnenden Merkmalen des Anspruchs 1. Vorrichtungsmäßig wird die Aufgabe durch eine gattungsgemäße Halbleiterspeichereinrichtung erfindungsgemäß mit den kennzeichnenden Merkmalen des Anspruchs 13 gelöst. Vorteilhafte Weiterbildungen des erfindungsgemäßen Herstellungsverfahren bzw. der erfindungsgemäßen Halbleiterspeichereinrichtung sind jeweils Gegenstand der abhängigen Unteransprüche.

Bei dem gattungsgemäßen Verfahren zum Herstellen einer Halbleiterspeichereinrichtung, insbesondere eines MRAM-Speichers oder dergleichen, wird in einem sich im Wesentlichen lateral erstreckenden Materialbereich und/oder als Teil davon eine Mehrzahl Speicherelemente jeweils lateral voneinander beabstandet ausgebildet. Des Weiteren wird jeweils mindestens eine Kondensatoreinrichtung vorgesehen mit jeweils mindestens einer ersten oder unteren Elektrodeneinrichtung und einer zweiten oder oberen Elektrodeneinrichtung und einem im Wesentlichen dazwischen ausgebildeten Dielektrikum.

Das erfindungsgemäße Herstellungsverfahren ist dadurch gekennzeichnet, dass die erste oder untere Elektrodeneinrichtung und/oder die zweite oder obere Elektrodeneinrichtung im Wesentlichen direkt unterhalb bzw. direkt oberhalb des die Speicherelemente aufweisenden Materialbereichs ausgebildet werden und dass dadurch - zumindest im Betrieb - zumindest ein Teil des die Speicherelemente aufweisenden Materialbereichs zumindest als Teil des jeweiligen Dielektrikums vorgesehen wird.

Es ist somit eine Kernidee des vorliegenden erfindungsgemä-ßen Herstellungsverfahrens, die Ausbildung der jeweiligen Elektrodeneinrichtungen sowie des dazwischen vorgesehenen Dielektrikums dadurch in den bestehenden Herstellungsprozess zu integrieren und dadurch die Anzahl zusätzlicher Prozessschritte zu verringern, dass die jeweiligen Elektrodeneinrichtungen im Wesentlichen direkt unterhalb bzw. direkt oberhalb desjenigen Materialbereichs ausgebildet werden, welcher die jeweiligen Speicherelemente aufweist, wobei dies so erfolgt, dass zumindest ein Teil des Materialbereichs einen Teil des zwischen den Elektroden vorzusehenden Dielektrikums bildet. Dadurch wird erreicht, dass mit dem Prozessieren der jeweiligen Speicherelemente zumindest ein Teil der für die Ausbildung der Elektrodeneinrichtungen und des Dielektrikums notwendigen Prozessschritte im Wesentlichen simultan mit erfolgen kann. Dies betrifft insbesondere die Ausbildung des Dielektrikums, weil zum Beispiel der Materialbereich als Aufnahmebereich für die Speicherelemente ohnehin ausgebildet werden muss und somit zum Beispiel Zwischenbereiche des betreffenden Materialbereïchs zwischen benachbarten Speicherelementen oder Speicherzellen folglich als Dielektrikum dienen können.

Bei einer bevorzugten Ausführungsform des erfindungsgemäßen Verfahrens ist es vorgesehen, dass die Speicherelemente als magnetoresistive Speicherelemente, insbesondere als TMR-Stapelelemente oder dergleichen, ausgebildet werden.

Ferner ist es vorgesehen, dass die Speicherelemente mehrschichtig ausgebildet werden, insbesondere mit einer zwischen einer hartmagnetischen Schicht und einer weichmagnetischen Schicht vorgesehenen Tunnelschicht, wobei insbesondere von der Tunnelschicht abgewandt eine Barriereschicht an der hartmagnetischen Schicht und/oder an der weichmagnetischen Schicht begrenzend ausgebildet werden.

Durch diese Maßnahmen wird die Ausbildung der notwendigen Kondensatoreinrichtungen gerade in den Prozessablauf für einen MRAM-Speicher integriert.

Insbesondere zu einer ersten Kontaktierung der Speicherelemente ist es in vorteilhafter Form vorgesehen, dass die Speicherelemente auf einem ersten Metallisierungsbereich ausgebildet werden, insbesondere auf einer ersten Zugriffsleitungseinrichtung und/oder insbesondere mit jeweils der ersten Barriereschicht davon zuunterst, wobei der erste Metallisierungsbereich im Wesentlichen direkt unterhalb des die Speicherelemente aufweisenden Materialbereichs vorgesehen wird. Dadurch ergibt sich insbesondere die Möglichkeit, diesen ersten Metallisierungsbereich, insbesondere also die erste Zugriffsleitungseinrichtung, gemeinsam mit der ersten oder unteren Elektrodeneinrichtung der Kondensatoreinrichtung auszubilden.

Bei einer anderen bevorzugten Ausführungsform des erfindungsgemäßen Verfahrens ist es vorgesehen, dass, insbesondere zu einer zweiten Kontaktierung der Speicherelemente, ein zweiter Metallisierungsbereich vorgesehen wird, insbesondere als jeweils eine zweite Zugriffsleitungseinrichtung und/oder insbesondere im Wesentlichen in Kontakt mit dem jeweiligen Speicherelement, insbesondere mit der jeweiligen zweiten Barriereschicht davon. Durch diese Maßnahme wird eine obere Kontaktierung der Speicherzellen erreicht und ermöglicht darüber hinaus das simultane Ausbilden der jeweiligen zweiten Metallisierungsschicht bzw. der zweiten Zugriffsleitungseinrichtung zusammen mit der zweiten oder oberen Elektrodeneinrichtung der Kondensatoreinrichtung.

Bei einer anderen bevorzugten Ausführungsform des erfindungsgemäßen Verfahrens ist es vorgesehen, dass die erste oder untere Elektrodeneinrichtung und/oder die zweite oder obere Elektrodeneinrichtung mit dem ersten Metallisierungsbereich bzw. mit dem zweiten Metallisierungsbereich im Wesentlichen in einer Ebene und/oder in einem jeweils gemeinsamen Materialbereich liegend ausgebildet werden.

Es ist ferner vorgesehen, dass die erste oder untere Elektrodeneinrichtung und/oder die zweite oder obere Elektrodeneinrichtung im Wesentlichen räumlich lateral beabstandet ausgebildet werden zum ersten Metallisierungsbereich bzw. zum zweiten Metallisierungsbereich. Dadurch wird gerade eine räumliche und/oder entsprechend eine elektrische Trennung der jeweiligen Elektrodeneinrichtungen von den Metallisierungsbereichen bzw. von den Zugriffsleitungseinrichtungen erreicht.

Zusätzlich kann es vorgesehen sein, dass die erste oder untere Elektrodeneinrichtung und/oder die zweite oder obere Elektrodeneinrichtung im Wesentlichen elektrisch isoliert ausgebildet werden zum ersten Metallisierungsbereich bzw. zum zweiten Metallisierungsbereich und dass dazu insbesondere im Wesentlichen elektrisch isolierende Spacerelemente im Zwischenbereich zwischen der ersten oder unteren Elektrodeneinrichtung und dem ersten Metallisierungsbereich und/oder der zweiten oder oberen Elektrodeneinrichtung und dem zweiten Metallisierungsbereich vorgesehen sind.

Durch diese Maßnahme wird gerade der Notwendigkeit der räumlichen Beabstandung und/oder der elektrischen Isolation der jeweiligen Elektrodeneinrichtungen von den Metallisierungsbereichen Genüge getan.

Bei einer anderen Ausführungsform des erfindungsgemäßen Verfahrens ist es vorgesehen, dass entweder die erste oder untere Elektrodeneinrichtung oder aber die zweite oder obere Elektrodeneinrichtung in im Wesentlichen elektrischem Kontakt ausgebildet wird mit dem ersten Metallisierungsbereich bzw. mit dem zweiten Metallisierungsbereich und dass dazu insbesondere entweder die erste oder untere Elektrodeneinrichtung oder die zweite oder obere Elektrodeneinrichtung mit dem ersten Metallisierungsbereich bzw. mit dem zweiten Metallisierungsbereich einteilig oder einstückig ausgebildet wird.

Durch diese Maßnahme wird der Herstellungsprozess weiter vereinfacht, weil dann nämlich genau eine der Elektrodeneinrichtungen zusammen mit dem entsprechenden Metallisierungsbereich oder der entsprechenden Zugriffsleitungseinrichtung simultan ausgebildet werden kann. Es darf dabei aber immer nur eine Kombination realisiert werden, weil ansonsten ein Kurzschluss der beiden Elektrodeneinrichtungen, mithin also der Kondensatoranordnung entstünde.

Die folgenden Maßnahmen dienen der weiteren Integration der für die Ausbildung der Kondensatoreinrichtung notwendigen Prozessschritte in die Prozessabfolge zur Ausbildung der eigentlichen Halbleiterspeichereinrichtung.

Dazu ist es insbesondere vorgesehen, dass die erste oder untere Elektrodeneinrichtung und der erste Metallisierungsbereich und/oder die zweite oder obere Elektrodeneinrichtung und der zweite Metallisierungsbereich jeweils in einem im Wesentlichen gemeinsamen Prozessschritt, in einer gemeinsamen kaskadierten Prozessabfolge oder dergleichen ausgebildet werden.

Besonders vorteilhaft ist dabei, dass die erste oder untere Elektrodeneinrichtung und der erste Metallisierungsbereich und/oder die zweite oder obere Elektrodeneinrichtung und der zweite Metallisierungsbereich jeweils ausgebildet werden durch Abscheiden und Strukturieren entsprechender Metallisierungsbereiche oder dergleichen, nachfolgendes Einbetten in Passivierungsbereiche und gegebenenfalls nachfolgendes Planarisieren oder Polieren auf ein Niveau eines gemeinsamen Oberflächenbereichs.

Hierbei werden also zunächst die Metallisierungsbereiche, aus denen dann später zum einen die Elektrodeneinrichtungen und zum anderen die Zugriffsleitungseinrichtungen gebildet werden sollen, ausgebildet. Dann werden die jeweiligen, gegebenenfalls auch getrennt vorgesehenen, Metallisierungsbereiche, in einen Passivierungsbereich eingebettet, indem nämlich ein entsprechendes elektrisch isolierendes Material die Zwischenbereiche zwischen dem Metallisierungsbereichen auffüllend abgeschieden wird. Gegebenenfalls muss dann noch mit einem entsprechenden Polierverfahren die Gesamtstruktur bis auf ein gemeinsames Niveau oder einen gemeinsamen Oberflächenbereich hin planarisiert werden.

Andererseits kann zunächst auch ein Passivierungsbereich ausgebildet werden, insbesondere durch ein entsprechendes Abscheidungsverfahren. Dann können in diesem abgeschiedenen Passivierungsbereich entsprechende Ausnehmungen, nämlich an den Stellen der auszubildenden Elektrodeneinrichtungen und der auszubildenden Zugriffsleitungseinrichtungen, ausgebildet werden. Diese Ausnehmungen werden dann nachfolgend mit einem entsprechenden, im Wesentlichen elektrisch leitenden Material, vorzugsweise mit einem Metall, gefüllt.

Im Folgenden wird die vorrichtungsmäßige Lösung der der Erfindung zugrundeliegenden Aufgabe diskutiert:

Bei der gattungsgemäßen Halbleiterspeichereinrichtung, insbesondere MRAM-Speichereinrichtung oder dergleichen, ist in einem sich im Wesentlichen lateral erstreckenden Materialbereich und/oder oder als Teil davon eine Mehrzahl Speicherelemente jeweils lateral voneinander beabstandet ausgebildet. Des Weiteren ist mindestens eine Kondensatoreinrichtung vorgesehen, mit jeweils mindestens einer ersten oder unteren Elektrodeneinrichtung und einer zweiten oder oberen Elektrodeneinrichtung und einem im Wesentlichen dazwischen ausgebildeten Dielektrikum.

Die erfindungsgemäße Halbleiterspeichereinrichtung ist dadurch gekennzeichnet, dass die erste oder untere Elektrodeneinrichtung und/oder die zweite oder obere Elektrodeneinrichtung im Wesentlichen direkt unterhalb bzw. direkt oberhalb des Speicherelemente aufweisenden Materialbereichs ausgebildet sind und dass dadurch - zumindest im Betrieb - zumindest ein Teil des Speicherelemente aufweisenden Materialbereichs zumindest als Teil des jeweiligen Dielektrikums vorgesehen ist.

Es ist somit eine Grundidee der vorliegenden erfindungsgemä-ßen Halbleiterspeichereinrichtung, den ohnehin vorzusehenden Materialbereich zur Aufnahme der einzelnen Speicherelemente gleichzeitig auch als Dielektrikum zwischen den Elektrodeneinrichtungen der auszubildenden Kondensatoreinrichtungen zu verwenden.

Gemäß einer bevorzugten Ausführungsform der erfindungsgemä-ßen Halbleiterspeichereinrichtung ist es vorgesehen, dass die Speicherelemente als magnetoresistive Speicherelemente, insbesondere als TMR-Stapelelemente oder dergleichen, ausgebildet sind.

Ferner ist es vorgesehen, dass die Speicherelemente mehrschichtig ausgebildet sind, insbesondere mit einem zwischen einer hartmagnetischen Schicht und einer weichmagnetischen Schicht vorgesehenen Tunnelschicht, wobei insbesondere von der Tunnelschicht abgewandt eine Barriereschicht an der hartmagnetischen Schicht und/oder an der weichmagnetischen Schicht angrenzend ausgebildet sind.

Durch diese beiden Maßnahmen ist gerade die Anwendung der erfindungsgemäßen Halbleiterspeichereinrichtung bei typischen MRAM-Speichern oder dergleichen realisiert.

Insbesondere zu einer ersten Kontaktierung der Speicherelemente ist es vorgesehen, dass gemäß einer weiteren Ausführungsform der erfindungsgemäßen Halbleiterspeichereinrichtung die Speicherelemente auf einem ersten Metallisierungsbereich ausgebildet sind, insbesondere auf einer ersten Zugriffsleitungseinrichtung und/oder insbesondere mit jeweils der ersten Barriereschicht davon zuunterst, wobei der erste Metallisierungsbereich im Wesentlichen direkt unterhalb des die Speicherelemente aufweisenden Materialbereichs vorgesehen ist.

Bei einer anderen Ausführungsform der erfindungsgemäßen Halbleiterspeichereinrichtung ist es vorgesehen, dass, insbesondere zu einer zweiten Kontaktierung der Speicherelemente, ein zweiter Metallisierungsbereich vorgesehen ist, insbesondere als jeweils eine zweite Zugriffsleitungseinrichtung und/oder insbesondere im Wesentlichen in Kontakt mit dem jeweiligen Speicherelement, insbesondere mit der jeweiligen zweiten Barriereschicht davon.

Durch die beiden zuletzt genannten Maßnahmen wird erreicht, dass in den Prozessen zur Ausbildung eines Dielektrikums auch die Verfahrensschritte zur Ausbildung der ersten und zweiten Elektrodeneinrichtungen der Kondensatoreinrichtung mit den Vorgängen zur Ausbildung der ersten und zweiten Metallisierungsbereiche, insbesondere der ersten und zweiten Zugriffsleitungseinrichtungen, integriert ausgeführt werden können.

Gemäß einer anderen Ausführungsform der erfindungsgemäßen Halbleiterspeichereinrichtung ist es vorgesehen, dass die erste oder untere Elektrodeneinrichtung und/oder die zweite oder obere Elektrodeneinrichtung mit dem ersten Metallisierungsbereich bzw. mit dem zweiten Metallisierungsbereich im Wesentlichen in einer Ebene und/oder in einem jeweils gemeinsamen Materialbereich liegend ausgebildet sind.

Es ist weiterhin von Vorteil, dass die erste oder untere Elektrodeneinrichtung und/oder die zweite oder obere Elektrodeneinrichtung im Wesentlichen räumlich lateral beabstandet ausgebildet sind zum ersten Metallisierungsbereich bzw. zum zweiten Metallisierungsbereich. Dadurch wird eine entsprechend notwendige elektrische Isolation auf einfache Art und Weise bewerkstelligt.

Ferner ist es von Vorteil, dass die erste oder untere Elektrodeneinrichtung und/oder die zweite oder obere Elektrodeneinrichtung im Wesentlichen elektrisch isoliert ausgebildet sind, zum ersten Materialbereich bzw. zum zweiten Materialbereich und dass dazu insbesondere im Wesentlichen elektrisch isolierende Spacerelemente im Zwischenbereich zwischen der ersten oder unteren Elektrodeneinrichtung und dem ersten Metallisierungsbereich und/oder der zweiten oder oberen Elektrodeneinrichtung und dem zweiten Metallisierungsbereich vorgesehen sind.

Andererseits ist es auch möglich, dass entweder die erste oder untere Elektrodeneinrichtung oder die zweite oder obere Elektrodeneinrichtung in im Wesentlichen elektrisch leitendem Kontakt ausgebildet ist mit dem ersten Metallisierungsbereich bzw. mit dem zweiten Metallisierungsbereich und dass dazu insbesondere entweder die erste oder untere Elektrodeneinrichtung oder die zweite oder obere Elektrodeneinrichtung mit dem ersten Metallisierungsbereich bzw. mit dem zweiten Metallisierungsbereich einteilig oder einstückig ausgebildet ist.

Diese und weitere Aspekte der vorliegenden Erfindung ergeben sich auch aus den nachstehenden Bemerkungen:

Insbesondere magnetische Speicherzellen (MRAMs) sind ein neuer Typ elektronischer Speicherzellen. Die Notwendigkeit der on-chip-Realisierung von passiven Bauelementen, wie Kondensatoreinrichtungen oder dergleichen, ergibt sich aus Aspekten der Funktionsverlässlichkeit der entsprechenden Halbleiterspeichereinrichtungen. Die vorliegende Erfindung bereitet einen Weg, bei welchem kapazitive Elemente in hochintegrierte (deep-sub-micrometer) magnetische Speicherzellen einzubetten, ohne dass zusätzliche Prozessschritte notwendig sind.

Beispielsweise können entsprechende Kondensatorstrukturen mit im Wesentlichen vertikalem Aufbau in ein entsprechendes Speicherzellenarray angeordnet werden. Dabei erstreckt sich die Abfolge von unterer Elektrode, Dielektrikum und oberer Elektrode in vertikaler Richtung. Zum einen sind dabei eine untere Metallisierungsebene M2, eine obere Metallisierungsebene M3 sowie eine sogenannte TMR-Schichtstruktur mit einem entsprechenden einbettenden Materialbereich und gegebenenfalls mit Hartmaske HM vorgesehen. Dieser Aufbau schafft die notwendige laterale Distanz oder Beabstandung zwischen den TMR-Elementen oder -Stapeln zu den jeweiligen unteren oder oberen Elektroden der Kondensatoreinrichtungen und verhindert somit die Gefahr von Kurzschlüssen.

Es sind aber auch andere Varianten möglich, wobei die zweite Metallschicht M2 unterhalb der TMR-Schicht und isoliert von dieser angeordnet ist, bei welcher die Metallschicht M2 unterhalb des TMR-Stapels nicht isoliert angeordnet ist, bei welcher die Metallschicht M3 oberhalb des TMR-Stapels isoliert angeordnet ist und eine Anordnung, bei welcher die Metallschicht M3 oberhalb des TMR-Stapels nicht isoliert angeordnet ist.

Es sind auch entsprechende horizontale Layouts denkbar.

Praktisch ist jedes Design oder Layout möglich, solange nur die TMR-Stapel oder -Stützbereiche nicht beide Metallschichten M2 und M3, nämlich die untere und die obere Elektrodeneinrichtung der Kondensatoreinrichtungen, ankontaktieren.

Nachfolgend wird die Erfindung anhand bevorzugter Ausführungsformen der erfindungsgemäßen Halbleiterspeichereinrichtung auf der Grundlage einer schematischen Zeichnung näher erläutert.

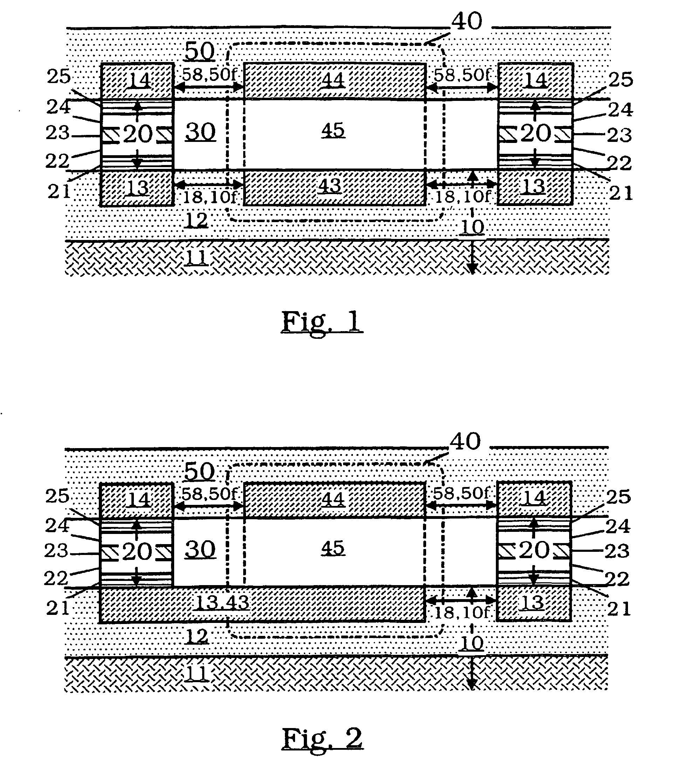

- **Fig. 1 - 3**: zeigen jeweils eine Ausführungsform der erfindungsgemäßen Halbleiterspeichereinrichtung in schematischer und geschnittener Seitenansicht.

Bei den nachfolgenden Fig. 1 - 3 bezeichnen dieselben Bezugszeichen immer dieselben Strukturen oder Elemente, und die entsprechenden detaillierten Beschreibungen werden nicht in jedem Fall wiederholt.

Fig. 1 zeigt in geschnittener Seitenansicht den Aufbau einer ersten Ausführungsform der erfindungsgemäßen Halbleiterspeichereinrichtung 1.

Die Grundstruktur 10 der Ausführungsform der Fig. 1 wird gebildet von einem eigentlichen Halbleitersubstrat 11, in welches gegebenenfalls eine entsprechende CMOS-Struktur ausgebildet und eingebettet ist. Abgedeckt wird diese CMOS-Struktur von einem ersten Passivierungsbereich 12. In diesen Passivierungsbereich 12 sind erste Zugriffsleitungseinrichtungen 13 eingebettet und ausgebildet. Oberhalb dieser ersten Metallisierungsbereiche oder ersten Zugriffsleitungseinrichtungen 13 sind jeweils Speicherelemente 20 ausgebildet, die mehrschichtig aufgebaut sind und eine erste oder untere Barriereschicht 21, eine hartmagnetische Schicht 22, eine Tunnelbarrierenschicht 23, eine weichmagnetische Schicht 24, eine obere Barrierenschicht 25 und gegebenenfalls eine Schutzschicht aufweisen.

Angrenzend an die obere Barriereschicht 25 oder an die Schutzschicht für das Speicherelement 20 ist jeweils eine zweite Metallisierungsschicht 14 oder zweite Zugriffsleitungseinrichtung 14 vorgesehen. Die erste Zugriffsleitungseinrichtung 13 und die zweite Zugriffsleitungseinrichtung 14 können zum Beispiel durch sogenannte Bitleitungen oder Wortleitungen gebildet werden.

Bei der Ausführungsform der Fig. 1 ist in räumlicher Nachbarschaft zur jeweiligen ersten Zugriffsleitungseinrichtung 13 eine erste Elektrodeneinrichtung 43 einer Kondensatoreinrichtung 40 ausgebildet, welche durch entsprechende Zwischenbereiche 18 und entsprechende Spacerelemente 10f von den jeweiligen Zugriffsleitungseinrichtungen 13 räumlich getrennt und elektrisch isoliert ist.

Andererseits sind die zweiten Zugriffsleitungseinrichtungen 14 in einem zweiten Passivierungsbereich 50 derart eingebettet, dass zwischen den zweiten Zugriffsleitungseinrichtungen 14 und einer vorgesehenen zweiten oder oberen Elektrodeneinrichtung 44 der Kondensatoreinrichtung 40 zweite Zwischenbereiche 58 bzw. entsprechende Spacerelemente 50f ebenfalls zur räumlichen Beabstandung und elektrischen Isolation vorgesehen sind.

Bei der Ausführungsform der Fig. 2 ist die erste oder untere Zugriffsleitungseinrichtung 13 lateral verbreitert ausgebildet, so dass sie gleichzeitig die Funktion der ersten oder unteren Elektrodeneinrichtung 43 der Kondensatoreinrichtung 40 wahrnehmen kann.

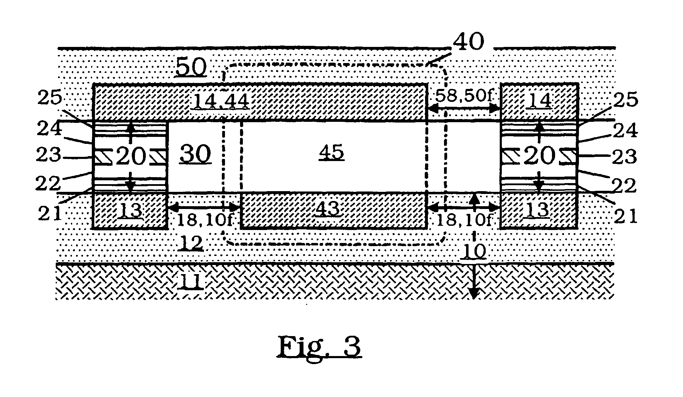

Bei der Ausführungsform der Fig. 3 ist im Gegensatz zur Ausführungsform der Fig. 1 die zweite oder obere Zugriffsleitungseinrichtung 14 mit größerer lateraler Erstreckung ausgebildet, so dass sie gleichzeitig oder einstückig die zweite oder obere Elektrodeneinrichtung 44 der Elektrodeneinrichtung 40 bildet.

Bei allen drei Ausführungsformen der Fig. 1 bis 3 nimmt der Materialbereich 30 zur Aufnahme der Speicherelemente 20 zumindest zum Teil auch die Funktion wahr, den entsprechenden Dielektrikumsbereich 45 für die Kondensatoreinrichtungen 40 zwischen den ersten und zweiten Elektrodeneinrichtungen 43 bzw. 44 bereitzustellen.

### Bezugszeichenliste

- 1: Halbleiterspeichereinrichtung
- 10: Grundstruktur
- 10f: Spacerelement
- 11: Halbleitersubstrat
- 12: Passivierungsbereich
- 13: erster Metallisierungsbereich, erste Zugriffsleitungseinrichtung
- 14: zweiter Metallisierungsbereich, zweite Zugriffsleitungseinrichtung
- 18: Zwischenbereich
- 20: Speicherelement, TMR-Stapelelement
- 21: untere Barriereschicht
- 22: hartmagnetische Schicht
- 23: Tunnelbarriereschicht
- 24: weichmagnetische Schicht
- 25: obere Barriereschicht
- 30: Materialbereich, Speicherelementebereich
- 40: Kondensatoreinrichtung
- 43: erste/untere Elektrodeneinrichtung
- 44: zweite/obere Elektrodeneinrichtung
- 45: Dielektrikum
- 50: zweiter Passivierungsbereich
- 50f: Spacerelement
- 58: Zwischenbereich

## Patentansprüche

1. Verfahren zum Herstellen einer Halbleiterspeichereinrichtung,
- bei welchem in einem sich lateral erstreckenden Materialbereich (30) eine Mehrzahl Speicherelemente (20) lateral voneinander beabstandet ausgebildet wird,
- bei welchem mindestens eine davon separate Kondensatoreinrichtung (40) ausgebildet wird mit einer ersten Elektrodeneinrichtung (43), einer zweiten Elektrodeneinrichtung (44) und einem Dielektrikum (45) dazwischen und
- bei welchem die erste Elektrodeneinrichtung (43) direkt unterhalb und die zweite Elektrodeneinrichtung (44) direkt oberhalb des die Speicherelemente (20) aufweisenden Materialbereichs (30) und derart ausgebildet werden,
- dass **dadurch** zumindest ein Teil des die Speicherelemente (20) aufweisenden Materialbereichs (30) zumindest als Teil des Dielektrikums (45) der separaten Kondensatoreinrichtung (40) ausgebildet wird.

2. Verfahren nach Anspruch 1,
**dadurch gekennzeichnet,**
**dass** die Speicherelemente (20) als magnetoresistive Speicherelemente oder als TMR-Stapelelemente ausgebildet werden.

3. Verfahren nach einem der vorangehenden Ansprüche,
**dadurch gekennzeichnet,**
**dass** die Speicherelemente (20) mehrschichtig ausgebildet werden mit einer zwischen einer hartmagnetischen Schicht (22) und einer weichmagnetischen Schicht (24) vorgesehenen Tunnelschicht (23), wobei von der Tunnelschicht (23) abgewandt eine Barriereschicht (21, 25) an der hartmagnetischen Schicht (22) oder an der weichmagnetischen Schicht (24) angrenzend ausgebildet wird.

4. Verfahren nach einem der vorangehenden Ansprüche,
**dadurch gekennzeichnet,**
**dass** zu einer ersten Kontaktierung der Speicherelemente (20) die Speicherelemente (20) auf einem ersten Metallisierungsbereich (13) ausgebildet werden mit jeweils einer ersten Barriereschicht (21) davon zuunterst, wobei der erste Metallisierungsbereich (13) im Wesentlichen direkt unterhalb des die Speicherelemente (20) aufweisenden Materialbereichs (30) vorgesehen wird.

5. Verfahren nach einem der vorangehenden Ansprüche,
**dadurch gekennzeichnet,**
**dass** zu einer zweiten Kontaktierung der Speicherelemente (20) ein zweiter Metallisierungsbereich (14) vorgesehen wird in Kontakt mit dem jeweiligen Speicherelement (20) und mit einer jeweiligen zweiten Barriereschicht (25) davon.

6. Verfahren nach einem der Ansprüche 4 oder 5,
**dadurch gekennzeichnet,**
**dass** die erste Elektrodeneinrichtung (43) und/oder die zweite Elektrodeneinrichtung (44) mit dem ersten Metallisierungsbereich (13) bzw. mit dem zweiten Metallisierungsbereich (14) in einer Ebene oder in einem jeweils gemeinsamen Materialbereich liegend ausgebildet werden.

7. Verfahren nach einem der Ansprüche 4 bis 6,
**dadurch gekennzeichnet,**
**dass** die erste Elektrodeneinrichtung (43) und/oder die zweite Elektrodeneinrichtung (44) räumlich lateral beabstandet ausgebildet werden zum ersten Metallisierungsbereich (13) bzw. zum zweiten Metallisierungsbere±ch (14)

8. Verfahren nach einem der Ansprüche 4 bis 7,
**dadurch gekennzeichnet,**
**dass** die erste Elektrodeneinrichtung (43) und/oder die zweite Elektrodeneinrichtung (44) elektrisch isoliert ausgebildet werden zum ersten Metallisierungsbereich (13) bzw. zum zweiten Metallisierungsbereich (14).

9. Verfahren nach einem der Ansprüche 4 bis 8,
**dadurch gekennzeichnet,**
- **dass** entweder die erste Elektrodeneinrichtung (43) oder aber die zweite Elektrodeneinrichtung (44) in elektrischem Kontakt ausgebildet wird mit dem ersten Metallisierungsbereich (43) bzw. mit dem zweiten Metallisierungsbereich (44)
und
- **dass** dazu insbesondere die erste Elektrodeneinrichtung (43) mit dem ersten Metallisierungsbereich (13) bzw. die zweite Elektrodeneinrichtung (44) mit dem zweiten Metallisierungsbereich (14) einteilig ausgebildet wird.

10. Verfahren nach einem der vorangehenden Ansprüche,
**dadurch gekennzeichnet,**
**dass** die erste Elektrodeneinrichtung (43) und der erste Metallisierungsbereich (13) und/oder die zweite Elektrodeneinrichtung (44) und der zweite Metallisierungsbereich (14) jeweils in einem gemeinsamen Prozessschritt oder in einer gemeinsamen Prozessabfolge ausgebildet werden.

11. Verfahren nach einem der vorangehenden Ansprüche,
**dadurch gekennzeichnet,**
**dass** die erste Elektrodeneinrichtung (43) und der erste Metallisierungsbereich (13) und/oder die zweite Elektrodeneinrichtung (44) und der zweite Metallisierungsbereich (14) jeweils ausgebildet werden durch Abscheiden und Strukturieren entsprechender Metallisierungsbereiche, nachfolgendes Einbetten in entsprechende Passivierungsbereiche und gegebenenfalls nachfolgendes Planarisieren auf ein Niveau eines gemeinsamen Oberflächenbereichs.

12. Verfahren nach einem der vorangehenden Ansprüche,
**dadurch gekennzeichnet,**
**dass** die erste Elektrodeneinrichtung (43) und der erste Metallisierungsbereich (13) und/oder die zweite Elektrodeneinrichtung (44) und der zweite Metallisierungsbereich (14) jeweils ausgebildet werden durch Abscheiden eines Passivierungsbereichs, Ausbilden entsprechender Ausnehmungen und Füllen der Ausnehmungen mit entsprechenden Metallisierungsbereichen.

13. Halbleiterspeichereinrichtung,
- bei welcher in einem sich lateral erstreckenden Materialbereich (30) eine Mehrzahl Speicherelemente (20) jeweils lateral voneinander beabstandet ausgebildet ist,
- bei welcher mindestens eine davon separate Kondensatoreinrichtung (40) ausgebildet ist mit jeweils mindestens einer ersten Elektrodeneinrichtung (43), einer zweiten Elektrodeneinrichtung (44) und einem Dielektrikum (45) dazwischen,
- bei welchem die erste Elektrodeneinrichtung (43) direkt unterhalb und die zweite Elektrodeneinrichtung (44) direkt oberhalb des die Speicherelemente (20) aufweisenden Materialbereichs (30) und derart ausgebildet sind,
- dass **dadurch** zumindest ein Teil des die Speicherelemente (20) aufweisenden Materialbereichs (30) zumindest als Teil des Dielektrikums (45) der separaten Kondensatoreinrichtung (40) dient.

14. Halbleiterspeichereinrichtung nach Anspruch 13,
**dadurch gekennzeichnet,**
**dass** die Speicherelemente (20) als magnetoresistive Speicherelemente oder als TMR-Stapelelemente ausgebildet sind.

15. Halbleiterspeichereinrichtung nach einem der vorangehenden Ansprüche 13 oder 14,
**dadurch gekennzeichnet,**
**dass** die Speicherelemente (20) mehrschichtig ausgebildet sind mit einer zwischen einer hartmagnetischen Schicht (22) und einer weichmagnetischen Schicht (24) vorgesehenen Tunnelschicht (23), wobei von der Tunnelschicht (23) abgewandt eine Barriereschicht (21, 25) an der hartmagnetischen Schicht (22) oder an der weichmagnetischen Schicht (24) angrenzend ausgebildet ist.

16. Halbleiterspeichereinrichtung nach einem der vorangehenden Ansprüche 13 bis 15,
**dadurch gekennzeichnet,**
**dass** zu einer ersten Kontaktierung der Speicherelemente (20) die Speicherelemente (20) auf einem ersten Metallisierungsbereich (13) ausgebildet sind mit jeweils einer ersten Barriereschicht (21) davon zuunterst, wobei der erste Metallisierungsbereich (13) direkt unterhalb des die Speicherelemente (20) aufweisenden Materialbereichs (30) ausgebildet ist.

17. Halbleiterspeichereinrichtung nach einem der vorangehenden Ansprüche 13 bis 16,
**dadurch gekennzeichnet,**
**dass** zu einer zweiten Kontaktierung der Speicherelemente (20) ein zweiter Metallisierungsbereich (14) vorgesehen ist in Kontakt mit dem jeweiligen Speicherelement (20) und mit einer jeweiligen zweiten Barriereschicht (25) davon.

18. Halbleiterspeichereinrichtung nach einem der vorangehenden Ansprüche 16 oder 17,
**dadurch gekennzeichnet,**
**dass** die erste Elektrodeneinrichtung (43) und/oder die zweite Elektrodeneinrichtung (44) mit dem ersten Metallisierungsbereich (13) bzw. mit dem zweiten Metallisierungsbereich (14) in einer Ebene und/oder in einem jeweils gemeinsamen Materialbereich liegend ausgebildet sind.

19. Halbleiterspeichereinrichtung nach einem der Ansprüche 16 bis 18,
**dadurch gekennzeichnet,**
**dass** die erste Elektrodeneinrichtung (43) und/oder die zweite Elektrodeneinrichtung (44) räumlich lateral beabstandet ausgebildet sind zum ersten Metallisierungsbereich (13) bzw. zum zweiten Metallisierungsbereich (14).

20. Halbleiterspeichereinrichtung nach einem der vorangehenden Ansprüche 16 bis 19,
**dass** die erste Elektrodeneinrichtung (43) und/oder die zweite Elektrodeneinrichtung (44) elektrisch isoliert ausgebildet sind zum ersten Metallisierungsbereich (13) bzw. zum zweiten Metallisierungsbereich (14).

21. Halbleiterspeichereinrichtung nach einem der vorangehenden Ansprüche 16 bis 20,
**dadurch gekennzeichnet,**
- **dass** entweder die erste Elektrodeneinrichtung (43) oder aber die zweite Elektrodeneinrichtung (44) in elektrischem Kontakt ausgebildet ist mit dem ersten Metallisierungsbereich (13) bzw. dem zweiten Metallisierungsbereich (14) und
- **dass** dazu insbesondere die erste Elektrodeneinrichtung (43) mit dem ersten Metallisierungsbereich (13) bzw. die zweite Elektrodeneinrichtung (44) mit dem zweiten Metallisierungsbereich (14) einstückig ausgebildet ist.

## Claims

1. Method for manufacturing a semiconductor memory device,
- in which a plurality of memory elements (20) are formed spaced apart from one another laterally in a material region (30) which extends laterally,
- in which at least one capacitor device (40) separate therefrom is formed, with a first electrode device (43), a second electrode device (44) and a dielectric (45) between them, and
- in which the first electrode device (43) is formed directly underneath and the second electrode device (44) directly above the material region (30) which has the memory elements (20), and in such a way
- that as a result at least a part of the material region (30) which has the memory elements (20) is provided at least as part of the dielectric (45) of the separate capacitor device.

2. Method according to Claim 1, **characterized in that** the memory elements (20) are formed as magnetoresistive memory elements, or as TMR stack elements.

3. Method according to one of the preceding claims, **characterized in that** the memory elements (20) are constructed with multiple layers, with a tunnel layer (23) provided between a hard magnetic layer (22) and a soft magnetic layer (24), a barrier layer (21, 25) being formed adjacent to the hard magnetic layer (22) or to the soft magnetic layer (24), facing away from the tunnel layer (23).

4. Method according to one of the preceding claims, **characterized in that**, for first making contact with the memory elements (20), the memory elements (20) are formed on a first metallization region (13), with in each case a first barrier layer (21) at the bottom, the first metallization region (13) being essentially provided directly underneath the material region (30) having the memory elements (20).

5. Method according to one of the preceding claims, **characterized in that**, for secondly making contact with the memory elements (20), a second metallization region (14) is provided, in contact with the respective memory element (20), and with a respective second barrier layer (25) thereof.

6. Method according to one of Claims 4 or 5, **characterized in that** the first electrode device (43) and/or the second electrode device (44) are formed with the first metallization region (13) and with the second metallization region (14), respectively, lying in a plane or in a respective common material region.

7. Method according to one of Claims 4 to 6, **characterized in that** the first electrode device (43) and/or the second electrode device (44) are formed spaced apart in a lateral spatial direction with respect to the first metallization region (13) or the second metallization region (14).

8. Method according to one of Claims 4 to 7, **characterized**
- **in that** the first electrode device (43) and/or the second electrode device (44) are formed electrically insulated from the first metallization region (13) and the second metallization region (14), respectively.

9. Method according to one of Claims 4 to 8, **characterized**
- **in that** either the first electrode device (43) or else the second electrode device (44) is formed in electrical contact with the first metallization region (43) and with the second metallization region (44), respectively,
and
- **in that**, for this purpose, in particular the first electrode device (43) or the second electrode device (44) is formed in one piece with the first metallization region (13) and the second metallization region (14), respectively.

10. Method according to one of the preceding claims, **characterized in that** the first or lower electrode device (43) and the first metallization region (13) and/or the second or upper electrode device (44) and the second metallization region (14) are each formed in a common process step or in a common process sequence.

11. Method according to one of the preceding claims, **characterized in that** the first electrode device (43) and the first metallization region (13) and/or the second electrode device (44) and the second metallization region (14) are each formed by depositing and patterning corresponding metallization regions, subsequently embedding in corresponding passivation regions and, if appropriate, subsequently planarizing to a level of a common surface region.

12. Method according to one of the preceding claims, **characterized in that** the first electrode device (43) and the first metallization region (13) and/or the second electrode device (44) and the second metallization region (14) are each formed by depositing a passivation region, forming corresponding recesses and filling in the recesses with corresponding metallization regions.

13. Semiconductor memory device,
- in which a multiplicity of memory elements (20) are formed respectively spaced apart from one another laterally in a material region (30) which extends laterally,
- in which at least one capacitor device (40) separate therefrom is formed, with in each case at least a first electrode device (43), a second electrode device (44) and a dielectric (45) between them,
- in which the first electrode device (43) is formed directly underneath and the second electrode device (44) directly above the material region (30) which has the memory elements (20), and in such a way
- that as a result at least a part of the material region (30) which the memory elements (20) is provided at least as part of the dielectric (45) of the separate capacitor device (40).

14. Semiconductor memory device according to Claim 13, **characterized in that** the memory elements (20) are formed as magnetoresistive memory elements or as TMR stack elements.

15. Semiconductor memory device according to one of the preceding Claims 13 or 14, **characterized in that** the memory elements (20) are constructed with multiple layers, with a tunnel layer (23) provided between a hard magnetic layer (22) and a soft magnetic layer (24), a barrier layer (21, 25) being formed adjacent to the hard magnetic layer (22) or to the soft magnetic layer (24), facing away from the tunnel layer (23).

16. Semiconductor memory device according to one of the preceding Claims 13 to 15, **characterized in that**, for first making contact with the memory elements (20), the memory elements (20) are formed on a first metallization region (13), with in each case a first barrier layer (21) at the bottom, the first metallization region (13) being formed directly underneath the material region (30) having the memory elements (20).

17. Semiconductor memory device according to one of the preceding Claims 13 to 16, **characterized in that**, for secondly making contact with the memory elements (20), a second metallization region (14) is provided, in contact with the respective memory element (20), and with a respective second barrier layer (25) thereof.

18. Semiconductor memory device according to one of the preceding Claims 16 or 17, **characterized in that** the first electrode device (43) and/or the second electrode device (44) are formed with the first metallization region (13) and with the second metallization region (14), respectively, lying in a plane and/or in a respective common material region.

19. Semiconductor memory device according to one of Claims 16 to 18, **characterized in that** the first electrode device (43) and/or the second electrode device (44) are formed spaced apart in a lateral spatial direction with respect to the first metallization region (13) and the second metallization region (14), respectively.

20. Semiconductor memory device according to one of the preceding Claims 16 to 19, **characterized**
- **in that** the first electrode device (43) and/or the second electrode device (44) are formed electrically insulated from the first metallization region (13) and the second metallization region (14), respectively.

21. Semiconductor memory device according to one of the preceding Claims 16 to 20, **characterized**
- **in that** either the first electrode device (43) or else the second electrode device (44) is formed in electrical contact with the first metallization region (13) and with the second metallization region (14), respectively, and
- **in that**, for this purpose, in particular the first electrode device (43) or the second electrode device (44) is formed in one piece with the first metallization region (13) and the second metallization region (14), respectively.

## Revendications

1. Procédé de production d'un dispositif de mémoire à semi-conducteurs
- dans lequel on forme, dans une partie (30) de matériau s'étendant latéralement, une pluralité d'éléments (20) de mémoire à distance latéralement les uns des autres,
- dans lequel on forme au moins un dispositif (40) de condensateur qui en est distinct et qui a un premier dispositif (43) d'électrode, un deuxième dispositif (44) d'électrode et un diélectrique (45) entre eux et
- dans lequel on forme le premier dispositif (43) d'électrode directement en dessous et le deuxième dispositif (44) d'électrode directement au-dessus de la partie (30) de matériau ayant les éléments (20) de mémoire et de sorte que
- au moins une partie de la partie (30) de matériau ayant les éléments (20) de mémoire soit formée ainsi au moins en partie du diélectrique (45) du dispositif (40) distinct de condensateur.

2. Procédé suivant la revendication 1,
**caractérisé**
**en ce que** l'on forme les éléments (20) de mémoire sous la forme d'éléments de mémoire magnétorésistifs ou d'éléments empilés TMR.

3. Procédé suivant l'une des revendications précédentes,
**caractérisé**
**en ce que** l'on forme les éléments (20) de mémoire en plusieurs couches comprenant une couche (23) tunnel prévue entre une couche (22) magnétique dure et une couche (24) magnétique douce, dans lequel, en s'éloignant de la couche (23) tunnel, une couche (21, 25) barrière est constituée en étant voisine de la couche (22) magnétique dure ou de la couche (24) magnétique douce.

4. Procédé suivant l'une des revendications précédentes,
**caractérisé**
**en ce que** l'on forme, pour une première mise en contact des éléments (20) de mémoire, les éléments (20) de mémoire sur une première partie (13) de métallisation ayant respectivement une première couche (21) barrière qui en est la plus basse, la première partie (13) de métallisation étant prévue sensiblement directement en dessous de la partie (30) de matériau ayant les éléments (20) de mémoire.

5. Procédé suivant l'une des revendications précédentes,
**caractérisé**
**en ce qu'**il est prévu, pour une deuxième mise en contact des éléments (20) de mémoire, une deuxième partie (14) de métallisation en contact avec l'élément (20) de mémoire respectif et avec une deuxième couche (25) barrière respective de celui-ci.

6. Procédé suivant l'une des revendications 4 ou 5,
**caractérisé**
**en ce que** le premier dispositif (43) d'électrode et/ou le deuxième dispositif (44) d'électrode sont constitués horizontalement avec la première partie (13) de métallisation ou avec la deuxième partie (14) de métallisation dans un plan ou dans une partie de matériau respectivement commune.

7. Procédé suivant l'une des revendications 4 à 6,
**caractérisé**
**en ce que** le premier dispositif (43) d'électrode et/ou le deuxième dispositif (44) d'électrode sont constitués latéralement à distance dans l'espace de la première partie (13) de métallisation ou de la deuxième partie (14) de métallisation.

8. Procédé suivant l'une des revendications 4 à 7,
**caractérisé**
**en ce que** le premier dispositif (43) d'électrode et/ou le deuxième dispositif (44) d'électrode sont isolés électriquement de la première partie (13) de métallisation ou de la deuxième partie (14) de métallisation.

9. Procédé suivant l'une des revendications 4 à 8,
**caractérisé en ce que**
- soit le premier dispositif (43) d'électrode, mais soit le deuxième dispositif (44) d'électrode est en contact électrique avec la première partie (43) de métallisation ou avec la deuxième partie (44) de métallisation
et
- **en ce qu'**à cet effet, notamment le premier dispositif (43) d'électrode est d'une seule pièce avec la première partie (13) de métallisation ou le deuxième dispositif (44) d'électrode est d'une seule pièce avec la deuxième partie (14) de métallisation.

10. Procédé suivant l'une des revendications précédentes,
**caractérisé**
**en ce que** le premier dispositif (43) d'électrode et la première partie (13) de métallisation et/ou le deuxième dispositif (44) d'électrode et la deuxième partie (14) de métallisation sont constitués respectivement dans un stade opératoire commun ou dans une succession commune d'opérations.

11. Procédé suivant l'une des revendications précédentes,
**caractérisé**
**en ce que** le premier dispositif (43) d'électrode et la première partie (13) de métallisation et/ou le deuxième dispositif (44) d'électrode et la deuxième partie (14) de métallisation sont constitués respectivement par dépôt et structuration de parties de métallisation adéquates, incorporation ensuite dans des parties correspondantes de passivation et, le cas échéant, planarisation ensuite jusqu'à un niveau d'une partie de surface commune.

12. Procédé suivant l'une des revendications précédentes,
**caractérisé**
**en ce que** le premier dispositif (43) d'électrode et la première partie (13) de métallisation et/ou le deuxième dispositif (44) d'électrode et la deuxième partie (14) de métallisation sont constitués respectivement par dépôt d'une partie de passivation, constitution d'évidements correspondants et remplissage des évidements par des parties de métallisation correspondantes.

13. Dispositif de mémoire à semi-conducteurs
- dans lequel il est constitué, dans une partie (30) de matériau s'étendant latéralement, une multiplicité d'éléments (20) de mémoire qui sont à distance latéralement les uns des autres,
- dans lequel il est constitué au moins un dispositif (40) de condensateur qui en est distinct et qui a respectivement un premier dispositif (43) d'électrode, un deuxième dispositif (44) d'électrode et un diélectrique (45) entre eux,
- dans lequel le premier dispositif (43) d'électrode est constitué directement en dessous et le deuxième dispositif (44) d'électrode directement au-dessus de la partie (30) de matériau ayant les éléments (20) de mémoire et de sorte que
- au moins une partie de la partie (30) de matériau ayant les éléments (20) de mémoire sert ainsi au moins comme partie du diélectrique (45) du dispositif (40) distinct de condensateur.

14. Dispositif de mémoire à semi-conducteur suivant la revendication 13,
**caractérisé**
**en ce que** les éléments (20) de mémoire sont constitués sous la forme d'éléments de mémoire magnétorésistifs ou d'éléments empilés TMR.

15. Dispositif de mémoire à semi-conducteur suivant l'une des revendications 13 ou 14 précédentes,
**caractérisé**
**en ce que** les éléments (20) de mémoire sont constitués en plusieurs couches ayant une couche (23) tunnel prévue entre une couche (22) magnétique dure et une couche (24) magnétique douce, dans lequel, en s'éloignant de la couche (23) tunnel, une couche (21, 25) barrière est constituée en étant voisine de la couche (22) magnétique dure ou de la couche (24) magnétique douce.

16. Dispositif de mémoire à semi-conducteur suivant l'une des revendications 13 à 15 précédentes,
**caractérisé**
**en ce que**, pour une première mise en contact des éléments (20) de mémoire, les éléments (20) de mémoire sont constitués sur une première partie de métallisation en ayant respectivement une première couche (21) barrière qui en est la plus basse, la première partie (13) de métallisation étant constituée directement en dessous de la partie (30) de matériau ayant les éléments (20) de mémoire.

17. Dispositif de mémoire à semi-conducteur suivant l'une des revendications 13 à 16 précédentes,
**caractérisé**
**en ce que**, pour une deuxième mise en contact des éléments (20) de mémoire, il est prévu une deuxième partie (14) de métallisation en contact avec l'élément (20) de mémoire respectif et avec une deuxième couche (25) barrière respective de celui-ci.

18. Dispositif de mémoire à semi-conducteur suivant l'une des revendications précédentes 16 ou 17,
**caractérisé**
**en ce que** le premier dispositif (43) d'électrode et/ou le deuxième dispositif (44) d'électrode sont constitués horizontalement avec la première partie (13) de métallisation
ou avec la deuxième partie (14) de métallisation dans un plan et/ou dans une partie de matériau respectivement commune.

19. Dispositif de mémoire à semi-conducteur suivant l'une des revendications 16 à 18,
**caractérisé**
**en ce que** le premier dispositif (43) d'électrode et/ou le deuxième dispositif (44) d'électrode sont constitués à distance latéralement dans l'espace de la première partie (13) de métallisation ou de la deuxième partie (14) de métallisation.

20. Dispositif de mémoire à semi-conducteur suivant l'une des revendications 16 à 19 précédentes,
**caractérisé**
**en ce que** le premier dispositif (43) d'électrode et/ou le deuxième dispositif (44) d'électrode sont isolés électriquement de la première partie (13) de métallisation ou de la deuxième partie (14) de métallisation.

21. Dispositif de mémoire à semi-conducteur suivant l'une des revendications 16 à 20 précédentes,
**caractérisé en ce que**
- soit le premier dispositif (43) d'électrode, mais soit le deuxième dispositif (44) d'électrode est en contact électrique avec la première partie (43) de métallisation ou avec la deuxième partie (44) de métallisation et
- **en ce qu'**à cet effet, notamment le premier dispositif (43) d'électrode est d'une seule pièce avec la première partie (13) de métallisation ou le deuxième dispositif (44) d'électrode est d'une seule pièce avec la deuxième partie (14) de métallisation.
